# EUROPEAN PATENT APPLICATION

(11) **EP 4 576 216 A1**
(43) Date of publication of application: **25.06.2025**
(21) Application number: 23219323.5
(22) Date of filing: 21.12.2023
(51) Int. Cl.: H01L 27/02, H01L 29/66, H01L 29/78

(54) **TRENCH ELECTROSTATIC DISCHARGE PROTECTION DEVICE**

(71) Applicant: Nexperia B.V., 6534 AB Nijmegen (NL)
(72) Inventor: Kumar, Manoj, 22529 Hamburg (DE); Khaund, Chinmoy, 22529 Hamburg (DE); Ong, Kilian, 22529 Hamburg (DE)
(74) Representative: Pjanovic, Ilija

(57) **Abstract**

A semiconductor device comprising trenches formed in a semiconductor substrate. The trenches comprises a plurality of ESD protection devices formed by PN or NP junctions between respective first doped regions (e.g. a P-doped region) and a second doped region (e.g. an N-doped region). The ESD protection devices are connected in series across the trenches by connection electrodes, which connect the trenches at corresponding points. The two outer trenches comprise ESD protection devices that are connected in parallel to first and second metal layers. The first and second metals between which the ESD protection devices are connected may, for example, be source and gate metal layers. An ESD event causes current to flow through the ESD protection devices.

## Description

### Technical Field

The present disclosure relates to a semiconductor device and in particular to a semiconductor device comprising electrostatic protection devices formed in trenches of a semiconductor device.

### Background

Electrostatic discharge (ESD) is the sudden transfer of charge between differently charged objects. Certain electrical components formed as part of semiconductor devices (e.g. MOS based transistor devices) are at risk of being damaged by ESD. This is particularly likely to be the case where the gate oxide layer of the transistor device is thinned to provide a lower threshold voltage for operation.

ESD protection devices may be used to protect against sudden ESD events, in order to prevent active components, e.g. transistors from suffering damage. Such ESD protection devices may comprise one or more diodes connected to an active electrical component. At least some of these diodes are arranged such that in the event of ESD, the current flows in the reverse direction through the diode, and hence the diodes only conduct current in the event of a sudden large voltage spike.

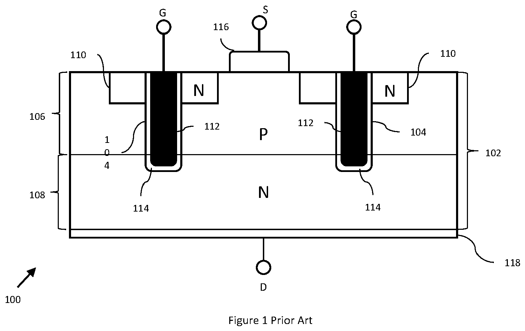

A type of electrical component that may require the implementation of ESD protection devices is a trench gate transistor device. Trench gate transistor devices are formed in trenches provided in a semiconductor substrate. Reference is made to Figure 1, which illustrates a semiconductor device 100 in which trench gate transistor devices are formed. The semiconductor device 100 comprises a substrate 102, a lower part 108 of the substrate 102 is an N doped region 108, whilst an upper part 106 of the substrate is a P doped region 106. The semiconductor device 100 further comprises trenches 104 formed in the substrate 102. Gate electrodes 112 are formed within the trenches 104 in the substrate 102 and insulating material 114 is formed on the sides of the trenches 104. A drain metal electrode 118 is formed on the lower side of the semiconductor substrate 102, whilst a source electrode 116 is formed on the upper side of the semiconductor substrate 102. When a positive voltage is applied to the gate electrodes 112, the transistor device is turned on and a current may flow vertically between the source electrode 116 and the drain electrode 118.

One of the challenges involved in providing ESD protection for active components, such as trench gate transistor devices, is integrating the ESD protection devices into the semiconductor device. One approach to providing ESD protection devices is to form a polysilicon layer above the semiconductor substrate and to form a plurality of P doped and N doped regions in the polysilicon layer, such that pairs of the P doped and N doped regions form PN junctions, hence providing diodes for providing ESD protection. However, an additional photomask may be required in order to define the polysilicon layer pattern, resulting in a more expensive manufacturing process.

### Summary

Hence, there is a need for integrating ESD protection circuits into a semiconductor device along with trench gate transistor devices. One proposal for achieving better integration has been to form short trenches or wells in the semiconductor substrate, where each well comprises a PN junction and/or an NP junction. The formation of these wells may eliminate the need for a further polysilicon layer formed above the substrate. However, the process required to produce such wells differs from the processes normally used to produce the trenches in active regions, e.g. the trenches in which the gates of transistors are formed. The formation of such different trench geometries increases the complexity and cost associated with fabricating the semiconductor device. Furthermore, surface area utilisation associated with the use of such wells may be sub-optimal.

According to a first aspect, there is provided a semiconductor device comprising: a semiconductor substrate comprising a plurality of trenches arranged in parallel, each of the trenches comprising a semiconductor comprising a plurality of first doped regions and a second doped region; a plurality of trench electrostatic discharge protection devices formed in the trenches and connected between a first metal layer formed above the semiconductor substrate and a second metal layer formed above the semiconductor substrate, wherein each of the plurality of trenches comprises two or more of the trench electrostatic discharge protection devices, wherein each of the plurality of trench electrostatic discharge protection devices comprises at least one of a PN junction or NP junction formed between one of the first doped regions and the second doped region of the respective trench, wherein the semiconductor device further comprising a plurality of connection electrodes formed above the semiconductor substrate for connecting the electrostatic discharge protection devices of each trench to the electrostatic protection devices of an adjacent at least one of the trenches, wherein for a first outer one of the trenches, the electrostatic discharge protection devices of the first outer one of the trenches are connected in parallel to the first metal layer, wherein for a second outer one of the trenches, the electrostatic discharge protection devices of the second outer one of the trenches are connected in parallel to the second metal layer.

Each of the trenches comprises a plurality of ESD protection devices formed by PN or NP junctions between respective first doped regions (e.g. a P-doped region) and a second doped region (e.g. an N-doped region). The ESD protection devices are connected in series across the trenches by connection electrodes, which connect the trenches at corresponding points. The two outer trenches comprise ESD protection devices that are connected in parallel to first and second metal layers. The first and second metals between which the ESD protection devices are connected may, for example, be source and gate metal layers. An ESD event causes current to flow through the ESD protection devices. The ESD protection devices are connected in parallel between a first metal layer, which may be connected to source electrodes of the transistors, and a second metal layer, which may be connected to gate electrodes of the transistors. Hence, the ESD protection devices are formed in parallel across trenches, enabling greater surface area utilisation and better integration with the techniques for forming trenches in a neighbouring active region. Furthermore, the use of the stripped arrangement of trenches make it possible to design a network ESD protection devices to achieve the appropriate current carrying capacity and breakdown voltage.

Two regions may be defined in the semiconductor device. A first region is an active region in which the trench gate transistors using first trenches are formed. The second region comprises the trenches (i.e. the second trenches) in which ESD protection devices are formed. The second trenches are arranged in parallel with the first trenches and used for the formation of the ESD protection devices.

The connection electrodes are configured to, for each of the electrostatic protection devices: provide a connection between a terminal of the respective electrostatic protection device and a terminal of a corresponding electrostatic protection device in the adjacent at least one of the trenches; and/or provide a connection between a terminal of the respective electrostatic protection device and terminals of a plurality of electrostatic protection devices in the adjacent at least one of the trenches. The electrostatic protection devices may be said to be corresponding if they are located in an equivalent position within different trenches.

In some embodiments, each of the connection electrodes form connections between: corresponding ones of the first doped regions belonging to different trenches; or the second doped regions belonging to different trenches. The first doped regions may be said to be corresponding if they are located in an equivalent position within different trenches.

In some embodiments, the semiconductor device further comprises: an insulating layer over the plurality of trenches; and conductive contacts formed through the insulating layer and connected to the connection electrodes.

In some embodiments, at least some of the conductive contacts are in contact with ones of the first doped regions of the trenches.

In some embodiments, some of the conductive contacts are in contact with ones of the second doped regions of the trenches.

In some embodiments, the plurality of trenches are a plurality of second trenches disposed in a second region of the semiconductor substrate, wherein the semiconductor device further comprises at least one first trench disposed in a first region defined in the semiconductor substrate, wherein one or more trench gate transistor devices are disposed in the first device region, the one or more trench gate transistor devices comprising gates disposed in the at least one first trench.

In some embodiments, the first metal layer is electrically connected to a first terminal of each of the trench gate transistor devices, wherein the second metal layer is electrically connected to a second terminal of each of the trench gate transistor devices.

In some embodiments, the second trenches are deeper than the at least one first trench.

In some embodiments, each of the connection electrodes is electrically connected between two corresponding first doped regions of adjacent ones of the trenches.

In some embodiments, some of the connections electrodes form connections with the second doped regions belonging to different trenches.

In some embodiments, each of the trenches comprises third doped regions electrically connected to ones of the connection electrodes connected to the respective trench, wherein each of the third doped regions comprises a same doping type as the first doped regions, wherein the third doped regions are more heavily doped that the first doped regions.

In some embodiments, the first metal layer is a source metal layer connected to a source terminal of a transistor of the semiconductor device.

In some embodiments, the second metal layer is a gate metal layer connected to a gate terminal of a transistor of the semiconductor device.

According to a second aspect, there is provided a method of manufacturing a semiconductor device according to any preceding claim, comprising producing each of the trenches by: etching the respective trench in the semiconductor substrate; implanting each of the first doped regions and the second doped region in the respective trench; forming an insulating layer over the respective trench; and forming electrical contacts through the insulating layer between the first doped regions and the second doped region of the respective trench, the method further comprising: forming the connection electrodes to connect the trenches by connecting the connection electrodes to some of the electrical contacts; and forming the first and second metal layers, including connecting them to others of the electrical contacts.

### Brief Description of Drawings

Features will become apparent to those of skill in the art by describing in detail example embodiments with reference to the attached drawings, in which:
Figure 1 illustrates prior art trench gate transistors;
Figure 2A illustrates a semiconductor device having an active region for forming trench gate transistors and a further region for forming electrostatic protection devices in trenches;
Figure 2B illustrates a further embodiment of the semiconductor devices in which the trenches for forming ESD protection devices are larger than the trenches of the active region;
Figure 3 is a top-view of the semiconductor device showing the arrangement of the trenches;
Figure 4A is a top-view of the ESD protection device trenches showing the metal connections above and in electrical contact with the semiconductor material in the trenches;
Figure 4B is a cross-section through one of the ESD protection device trenches showing the differently doped regions and metal contacts within the trenches;
Figure 4C is a further-cross section through one of the ESD protection device trenches showing the differently doped regions and metal contacts within the trenches;
Figure 5 illustrates a circuit diagram showing the circuit connecting the source and gate metal layers and further illustrating which PN junctions of the trenches form the elements of the circuit;
Figure 6 is a cross-section through an ESD protection device trench according to a further example embodiment in which additional PN junctions are formed in the trench;
Figure 7 illustrates a circuit diagram showing the circuit connecting the source and gate metal layers that is formed by ESD trenches according to the embodiment represented in Figure 6;
Figure 8 is a cross-section through an ESD protection device trench according to a further example embodiment in which heavily doped regions are included in the trenches; and
Figure 9 illustrates a steps in the construction of the ESD protection device trenches.

### Detailed Description

Embodiments will be described in more detail with reference to the accompanying Figures.

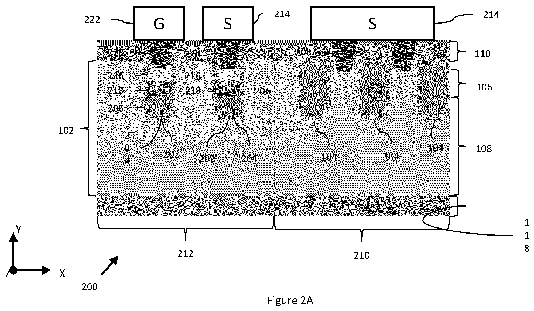

Reference is made to Figure 2A, which illustrates a cross-section through a semiconductor device 200 according to embodiments of the application. The semiconductor device 100 comprises a substrate 102, which may be formed of silicon. The semiconductor device comprises a first region 210 of the substrate 102, which is an active region 210 in which the trench gate transistors are formed. The trenches 104 for forming the gates of the transistors are shown as formed within this first region 210. The transistors formed within this region 210 may be the same as those shown in Figure 1. On the rear side of the substrate 102 is shown a drain metal layer 118, which provides the drain terminal of the transistors.

In Figure 2A, is shown an insulating layer 110 belonging to the semiconductor device 200 and informed on top of the semiconductor substrate 102. The insulating layer 110 is a dielectric layer, e.g. made of a silicate glass material. Over the first region 210 and within the insulating layer 110 are formed a plurality of conductive contacts 208, which connect between a source metal layer 214 and the region 106 of the substrate. The source metal layer 214 provides the source voltage to be applied to the source terminals of the transistors via the contacts 208.

As shown in Figure 2A, in addition to the active region 210, the semiconductor device 200 also comprises a second region 212 of the substrate 102. The second region 212 comprises the ESD protection devices, which are also formed in trenches.

The second region 212 comprises the ESD protection devices, which are also formed in trenches 202. In the embodiment shown in Figure 2A, the trenches 202 may be formed with the same trench geometry, e.g. the same width, depth, and length as the trenches 104 of the first region 210. Within the trenches is an insulating material 206, which separates a semiconductor material 204 formed in the trenches from the material of the semiconductor substrate 102. The semiconductor material 204 may be polysilicon 204. The semiconductor material 204 formed in the trenches comprises first doped regions 216 and second doped regions 218. In a number of the examples described herein, the first doped regions 216 are P-doped regions, whilst the second doped regions 218 are N-doped regions. However, in embodiments, the P-doping and N-doping regions may reversed, i.e. the first doped regions 216, described in the examples as being P-doped, may be N-doped, whilst the second doped regions 218, described in the examples as being N-doped, may be P-doped.

Within the insulating layer 110 are formed conductive contacts 220, which are in electrical contact with the P-doped regions 216 of the trenches 202. Some of these contacts 220 are in electrical contact with a metal layer 222 (which is a gate metal layer 222 in the example of Figure 2A), forming electrical connections between the gate metal layer 222 and the respective P-doped regions 216. Some of the contacts 220 are in electrical contact with the metal layer 214 (which is a source metal layer 214 in the example of Figure 2A) forming electrical connections between the source metal layer 214 and the respective P-doped regions 216.

Although the metal layers 214, 222 are shown in the example of Figure 2A as being source metal layers 214 and gate metal layer 222, the metal layers 214, 222 may be connected to other components than the source and gate terminal of a transistor. In other embodiments, one of the metal layers 214, 222 may be a drain metal layer for connection to the drain electrode 118 of the transistor, whilst another of the metal layers 214, 222 may be a gate metal layer. Therefore, the metal layer 214 is described herein as being a first metal layer 214, whilst the metal layer 222 is described herein as being a second metal layer 222.

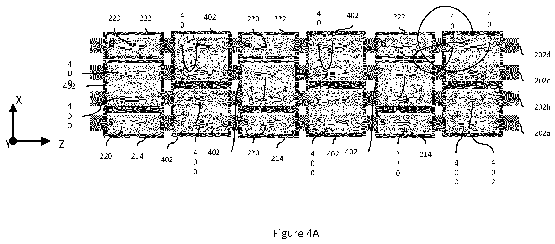

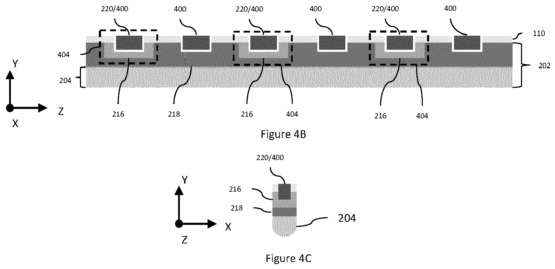

In addition to the contacts 220 shown in Figure 2A, further contacts may be formed to form connections between P-doped region or N-doped regions of different trenches 202 so as to form series connections between ESD protection devices implemented in different trenches 202. These connections are described in more detail with respect to Figures 4A and 4B.

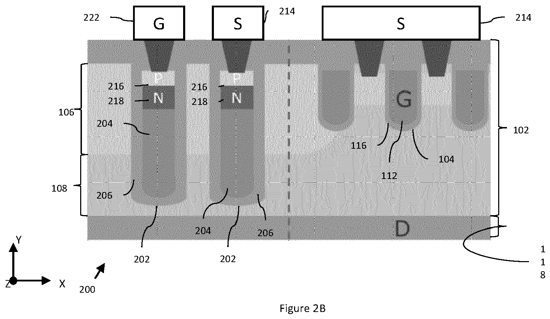

Reference is made to Figure 2B, which illustrates a further example embodiment of the semiconductor device in which the trenches 202 for forming the ESD protection devices are larger than the trenches 104. The smaller size trench ranges from 0.6. The trenches 202 in this embodiment are deep trench isolation (DTI) trenches. The deep isolation trenches may provide a higher breakdown voltage for the resulting ESD protection devices. The smaller sized trenches 202 shown in Figure 2A may be between 0.6µm and 1.8µm in depth. The deep sized trenches 202 shown in Figure 2B may be between 2 µm and 12 µm in depth.

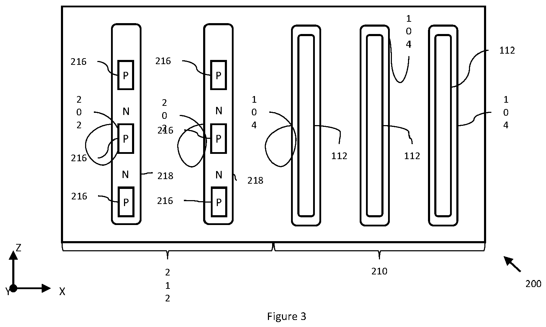

Reference is made to Figure 3, which illustrates a top-view of the semiconductor device 200. As illustrated, both sets of trenches 104 and 202 extend across the device 200 in a further direction (i.e. the Z-direction) that is perpendicular to the vertical direction (i.e. the Y-direction) in which the trenches are formed in the substrate 102. The trenches 104, 202 are arranged parallel to one another. The gate electrodes 114 are shown formed in the trenches 104. As shown, each of the trenches 202 comprises a plurality of P-doped regions 216, which are separated from one another by an N-doped region 218.

Reference is made to Figures 4A, 4B, and 4C, which illustrate views of the second region 212 of the semiconductor device 200. In the example shown, the semiconductor device 100 comprises four trenches 202a-d. However, there is an example only, and the number of trenches 202 may be a different number that is greater than or equal to two. Furthermore, the number of first doped-regions 216 is shown as being equal to three, but could be a different number.

Figure 4A is a top view showing the trenches 202a-d and the conductive structures above the trenches 202. The conductive structures may be made of copper. These conductive structures include the source metal layer 220 and the second metal layer 222 discussed with respect to Figures 2A and 2B. The source metal layer 220 is connected to the P-doped regions 216 of a first outer trench 202a, whilst the second metal layer 222 is connected to the P-doped regions 216 of a second outer trench 202d. The conductive structures also include connection electrodes 402 for forming connections between adjacent ones of the trenches 402a-d. The connection electrodes 402 may also be referred to as connection structures 402 and form a further metal layer for forming connections between the trenches 202a-d. Each of the trenches 202a-d is connected to its adjacent trenches (of which there are either one or two) via the connection electrodes 402. When the potential difference between the first and second metal layers 214, 222 is such that no current flows between the metal layers 214, 222, then the connection electrodes 402 are at a floating potential.

A first trench 202a located at one edge of the set of trenches 220a-d, is electrically connected at a number of points to the first metal layer 214. In the example, the semiconductor device 200 comprises three contacts 220 implemented in the insulating layer 110 that connect respective P-doped regions 216 of the trench 202a to respective parts of the first metal layer 214.

A second trench 202b located adjacent to the first trench 202a is electrically connected at a number of points to the first trench 202a. A plurality of contacts 400 are formed through the insulating layer 110 for connecting the N-doped regions 218 of the first and second trenches 202a, 202b to connection electrodes 402. The connection electrodes 402 are parts of a further metal layer for forming connections between the trenches 202a-d. In the example of Figures 4A-C, the device 200 comprises three contacts 400 forming electrical connections between the N-doped region 218 of the trench 202a and the connecting structures 402 and three contacts 400 forming electrical connections between the N-doped region 218 of the trench 202b and the same connecting structures 402. Hence, at these three points, the N-doped regions 218 of the trenches 202a, 202b are electrically connected.

A third trench 202c is located adjacent to the second trench 202b and is electrically connected to the second trench 202b. The connections are formed between respective P-doped regions 216 of the two trenches 202b, 202c. Contacts formed through the insulating layer 110, connect the P-doped regions of the trenches 202b, 202c to respective connecting structures 400. Hence, an electrical connection is formed between respective P-doped regions of the trenches 202b, 202c via the contacts 400 and the connecting structures 402.

A fourth trench 202d is located adjacent to the third trench 202c and is located at an edge of the set of trenches that is opposite to the edge at which the first trench 202a is located. A plurality of contacts 400 are formed through the insulating layer 110 for connecting the N-doped regions 218 of the third and fourth trenches 202a, 202b to connection electrodes 402, so as to electrically connect the N-doped regions of the third and fourth trenches 202c, 202d. Above the fourth trench 202d, a plurality of contacts 220 are formed in contact with the P-doped regions 216 of the fourth trench 202d. These contacts 220 are connected to the second metal layer 222.

By forming the connections between the trenches 202a-d in the manner described, a number of parallel electrical connections are formed between the second metal layer 222 and the first metal layer 214. Each parallel connection comprises a number of ESD protection devices arranged in series for providing a high breakdown voltage, such that current flows only in response to a large potential difference, e.g. resulting from an ESD event.

Reference is made to Figure 4B, which illustrates a further view of a trench 202 and its corresponding contacts 220/400, 400. The trench 202 may be any of the trenches 202a-d shown in Figure 4A. However, if the trench 202 is one of the outer trenches 202a,d, the contacts labelled as 220/400 are contacts 220. On the other hand, if the trench 202 is one of the inner trenches 202b,c, the contacts 220/400 are contacts 400.

As can be seen from Figure 4B, a number of PN junctions are formed in the trench 202 at each of the interface between the P-doped regions 216 and the corresponding N-doped regions 218. This results in a number of ESD protection devices 404 being formed in the trench 202. The ESD protection device 404 are connected to one another in parallel. In the example of Figures 4A-C, each ESD protection device 404 comprises a single PN junction and, therefore, is a diode.

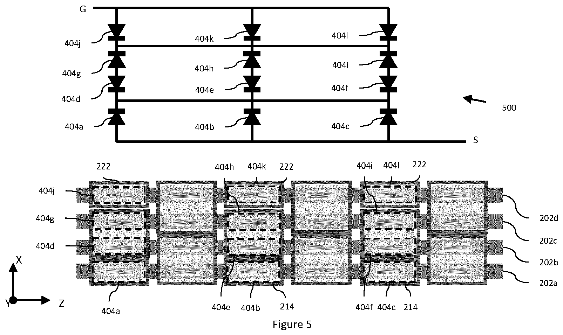

Reference is made to Figure 5, which show an example circuit diagram 500 showing the connections between the second metal layer (represented by `G') and the first metal layer (represented by `S'). Between the second metal layer and the first metal layer, there are a plurality of ESD protection devices 404a-I, which take the form of diodes. Also shown in Figure 5 are the locations of the ESD protection devices 404a-I in the different trenches 202a-d. As shown, ESD protection devices 404a,b,c comprise PN junctions formed in trench 202a. As a result, the ESD protection devices 404a,b,c are connected in parallel with one another between the first metal layer 214 and the N-doped region 218 of trench 202b.

ESD protection devices 404d,e,f comprise PN junctions formed in the trench 202b. Additionally, ESD protection devices 404g,h,i comprise PN junctions formed in the trench 202c. As a result of the connection electrodes 402 between the trenches 202b,c, the ESD protection devices 404d,g form a first pair of ESD protection devices connected in series between the trenches 202b,c, the ESD protection devices 404e,h form a second pair of ESD protection devices connected in series between the trenches 202b,c, the ESD protection devices 404f,i form a third pair of ESD protection devices connected in series between the trenches 202b,c. Each of these pairs of ESD protection devices is connected in parallel between the trenches 202b,c.

ESD protection devices 404j,k,l comprise PN junctions formed in trench 202d. As a result, the ESD protection devices 404j,k,l are connected in parallel with one another between the second metal layer 222 and the N-doped region 218 of trench 202d.

Embodiments have been described with respect to Figures 4A-C and 5, in which only some of the contacts 400 located in contact with a P-doped region 216, whilst others of the contacts 400 are located in contact with an N-doped region 218. Hence, there is only a single set of PN junctions arranged in parallel on the current path through each trench 202a-d between the first metal layer 214 and second metal layer 222. However, in other embodiments, there may be further P-doped regions implemented in each trench 202a-d in order to add further ESD protection devices to the semiconductor device 200.

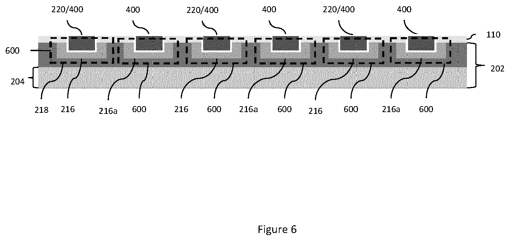

The ESD protection devices 404a-I provide protection against ESD events by allowing current to flow through the circuit 500 formed by these device 404a-I when a large potential difference exists between the first metal layer 214 and the second metal layer 222. Since the devices 404a-I comprise multiple diodes 404a-I implemented with different polarity, a large potential difference is required to cause current to flow (either from layer 214 to layer 222 or from layer 222 to layer 214) in the reverse direction through some of the diodes. The number of diodes 404a-I connected together in series can be increased to increase the breakdown voltage at which current flows between metal layers 214 and 222 through the circuit 500. The number of diodes 404a-I may be increased either by adding further trenches 202 to the set of trenches 202 or by adding additional P-doped regions connected to the connection electrodes 400 (as described below with reference to Figure 6). The total current carrying capacity of the circuit 500 may be increased by adding additional ESD devices connected in parallel. The example circuit 500 has sets of three ESD devices that are connected in parallel. However, by adding additional P-doped regions and connection electrodes, this number may be increased.

As noted (and as illustrated in Figures 2A and 2B) the first metal layer 214 may be connected to a source terminal of a transistor formed in the active region. Additionally, the second metal layer 222 may be connected to a gate terminal of a transistor formed in the active region. In the event of a large potential difference between the gate and source terminals of the transistor, the current flows through the circuit provided by the ESD protection device trenches 202 and hence protects the transistor.

Reference is made to Figure 6, which illustrates a further example embodiment in which additional P-doped regions 216a are implemented in each of the trenches 202 of the device. As a result of these additional P-doped regions 216a, a plurality of PN junctions and a plurality of NP junctions are implemented in each trench 202.

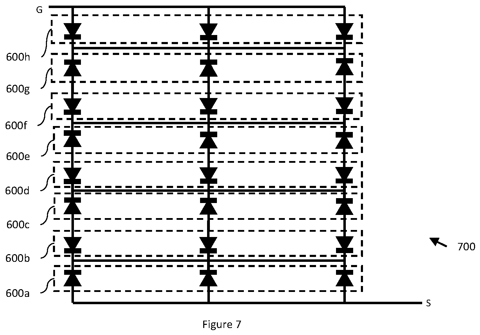

Reference is made to Figure 7, which illustrates a further circuit diagram 700 representing the circuit implemented between the first metal layer 214 and second metal layer 222 when additional P-doped regions 216a are implemented in each trench as shown in Figure 6. As shown, a first set 600a of ESD protection devices are arranged in parallel. These ESD protection devices are formed by the PN junctions formed between the P-doped regions 216 and the N-doped region of the first trench 202a. Each of the ESD protection devices of the first set 600a is connected to the ESD protection devices of a second set 600b of ESD protection devices, which are arranged in parallel. The ESD protection devices of the second set 600b are formed by the NP junctions formed between the N-doped region 218 and the additional P-doped regions 216a of the first trench 202a. Given that the junctions of the second set 600b are reversed as compared to the first set 600a (i.e. the second set 600b is formed of NP junctions, whereas the first set 600a is formed of PN junctions), the polarity of the diodes of the second set 600b is reversed compared to the polarity of the diodes of the first set 600a.

The second trench 202b comprises a third set 600c of ESD protection devices 202 arranged in parallel and formed by the PN junctions between P-doped regions 216 and the N-doped region 218 of that trench 202b. As seen, associated pairs of ESD protection devices belonging to the second set 600b and the third set 600c are arranged in series with one another, since they are connected by respective one of the connection electrodes 402. The second trench 202b further comprises a fourth set 600d of ESD protection devices arranged in parallel and formed by the NP junctions between the N-doped region 218 of that trench 202b and the P-doped regions of that trench 202b.

The third trench 202c comprises a fifth set 600e of ESD protection devices 202 arranged in parallel and formed by the PN junctions between P-doped regions 216 and the N-doped region 218 of that trench 202c. As seen, pairs of ESD protection devices belonging to the fourth set 600b and the fifth set 600e are arranged in series with one another, since they are connected by respective one of the connection electrodes 402. The third trench 202b further comprises a sixth set 600f of ESD protection devices arranged in parallel and formed by the NP junctions between the N-doped region 218 of that trench 202c and the P-doped regions 216 of that trench 202c.

The fourth trench 202d comprises a seventh set 600g of ESD protection devices 202 arranged in parallel and formed by the PN junctions between P-doped regions 216 and the N-doped region 218 of that trench 202d. As seen, pairs of ESD protection devices 202 belonging to the sixth set 600f and the seventh set 600g are arranged in series with one another, since they are connected by respective one of the connection electrodes 402. The fourth trench 202d further comprises an eighth set 600h of ESD protection devices arranged in parallel with one another and formed by the NP junctions between the N-doped region 218 of that trench 202d and the P-doped regions 216 of that trench 202d. The eight set 600h of ESD protection devices is connected to the second metal layer 222.

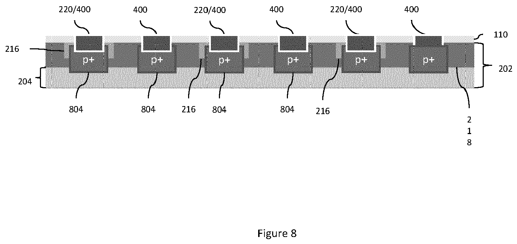

Reference is made to Figure 8, which illustrates an example trench 202 according to a further embodiment of the application. The trench 202 may be identical to the example trench 202 described above with respect to Figure 4B, but further comprising additional P-doped regions 804. These are heavily P-doped regions 804. The additional P-doped regions 804 are more heavily doped than the P-doped regions 216. The additional P-doped regions 804 may be a by-product of the trench gate transistor production process and so may achieve better integration with the trench gate transistors. The additional P-doped regions 804 may be the same material as the P-doped region in contact with the source terminal 116 of the trench gate transistor. The combination of the lighter P-doped regions 216 with the heavier P-doped regions 804 provides for a higher breakdown voltage of the ESD protection devices.

A number of different example embodiments have been described. Different aspects of these embodiments may be combined. For example, Figures 2A and B describe the use of different trench geometries for the trenches 202. Either of these trench geometries may be used for any of the embodiments of Figures 4A-C, Figure 6 or Figure 8. Furthermore, Figure 8 describes an example embodiment in which additional heavily doped regions are added to a trench 202. These additional heavily doped regions may also be applied to an embodiment in which the additional first doped regions 216a are present in each trench 202 (e.g. as in Figure 6).

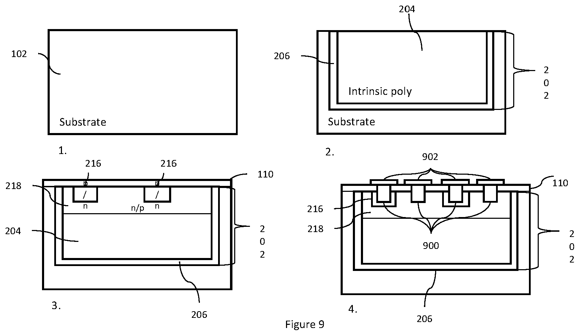

Reference is made to Figure 9, which illustrates stages that are part of the process for producing the ESD protection device trenches 202. The example trench shown in Figure 9 comprises only two first doped regions 216, however in other embodiments there may be more than two first doped regions 216.

At stage 1, the substrate 102 is provided. The substrate 102 is a semiconductor substrate 102, which may be a silicon substrate.

At stage 2, the trench 202 is created in the substrate 102 by trench etching. After etching the trench, a sacrificial oxide layer is grown on the walls of the trench 202 and then removed. The oxide lining 206 may then be formed on the walls of the trench 202. This oxide lining 206 formed in the trenches 202 is the same material and is deposited in the same way as the gate oxide 114 that provides the insulating layer 114 for the gate trenches 104. The oxide layer 206 forms the insulating layer 206. A polysilicon layer 204 is then deposited to fill the trench 202 via intrinsic polysilicon deposition.

At stage 3, the second doped-region 218 of the trench 202 is implanted. A contact mask is then used to define the first-doped regions 216 and the first-doped regions are implanted. The electrically insulating layer 110 is then formed on the surface of the substrate 102.

At stage 4, the contacts 900 are etched through the insulating layer 110 to form connections through the insulating layer 110 with the first-doped regions 216 and the second doped region 218. Each of the contacts 900 is one of the contacts 220/400 discussed earlier. The metal layers 902 are then deposited on each of the contacts. Each of the metal layers 902 is a connection electrode 402 or is part of the first metal layer 214 or second metal layer 222.

Figure 9 illustrates the process for constructing one trench 202, but a similar process may be followed for constructing other similar trenches 202. The metal layers 902 are formed on different trenches 202 to connect the trenches 202, between the first metal layer 214 and second metal layer 222, e.g. as discussed with respect to Figures 4A, 5 or 7.

A similar process to that illustrated in Figure 9 may be applied to produce the example trenches 202 shown in Figures 6 and 8. In the case of the Figure 6 embodiment, the process may be the same, but with additional first doped region implants 216a added at stage 3. In the case of the Figure 8 embodiment, the process may be the same, but with heavily doped region implants 804 added at Figure 8.

It would be appreciated that the embodiments have been described by way of example only.

## Claims

1. A semiconductor device comprising:
a semiconductor substrate comprising a plurality of trenches arranged in parallel, each of the trenches comprising a semiconductor comprising a plurality of first doped regions and a second doped region; and
a plurality of trench electrostatic discharge protection devices formed in the trenches and connected between a first metal layer formed above the semiconductor substrate and a second metal layer formed above the semiconductor substrate,
wherein each of the plurality of trenches comprises two or more of the trench electrostatic discharge protection devices, wherein each of the plurality of trench electrostatic discharge protection devices comprises at least one of a PN junction or NP junction formed between one of the first doped regions and the second doped region of the respective trench,
wherein the semiconductor device further comprising a plurality of connection electrodes formed above the semiconductor substrate for connecting the electrostatic discharge protection devices of each trench to the electrostatic protection devices of an adjacent at least one of the trenches,
wherein for a first outer one of the trenches, the electrostatic discharge protection devices of the first outer one of the trenches are connected in parallel to the first metal layer,
wherein for a second outer one of the trenches, the electrostatic discharge protection devices of the second outer one of the trenches are connected in parallel to the second metal layer.

2. A semiconductor device as claimed in claim 1, wherein the plurality of trenches are a plurality of second trenches disposed in a second region of the semiconductor substrate,
wherein the semiconductor device further comprises at least one first trench disposed in a first region defined in the semiconductor substrate, wherein one or more trench gate transistor devices are disposed in the first device region, the one or more trench gate transistor devices comprising gates disposed in the at least one first trench.

3. A semiconductor device as claimed in claim 2, wherein the first metal layer is electrically connected to a first terminal of each of the trench gate transistor devices,
wherein the second metal layer is electrically connected to a second terminal of each of the trench gate transistor devices.

4. A semiconductor device as claimed in claim 2 or claim 3, wherein the second trenches are deeper than the at least one first trench.

5. A semiconductor device as claimed in any preceding claim, wherein each of the connection electrodes is electrically connected between two corresponding first doped regions of adjacent ones of the trenches.

6. A semiconductor device as claimed in any of claims 1 to 4, wherein some of the connections electrodes form connections with the second doped regions belonging to different trenches.

7. A semiconductor device as claimed in any of claims 1 to 4, wherein each of the trenches comprises third doped regions electrically connected to ones of the connection electrodes connected to the respective trench, wherein each of the third doped regions comprises a same doping type as the first doped regions, wherein the third doped regions are more heavily doped that the first doped regions.

8. A semiconductor device as claimed in any preceding claim, wherein the first metal layer is a source metal layer connected to a source terminal of a transistor of the semiconductor device.

9. A semiconductor device as claimed in any preceding claim, wherein the second metal layer is a gate metal layer connected to a gate terminal of a transistor of the semiconductor device.

10. A method of manufacturing a semiconductor device according to any preceding claim, comprising producing each of the trenches by:
etching the respective trench in the semiconductor substrate;
implanting each of the first doped regions and the second doped region in the respective trench;
forming an insulating layer over the respective trench;
forming electrical contacts through the insulating layer between the first doped regions and the second doped region of the respective trench, the method further comprising:
forming the connection electrodes to connect the trenches by connecting the connection electrodes to some of the electrical contacts; and
forming the first and second metal layers, including connecting them to others of the electrical contacts.
